Europäisches Patentamt

European Patent Office

Office européen des brevets

(11) Publication number: **0 417 749 A2**

# EUROPEAN PATENT APPLICATION

(21) Application number: **90117525.7**

(22) Date of filing: **12.09.90**

(51) Int. Cl.5: **H01C 7/00, H05K 1/16,**
**//H01C1/14**

(30) Priority: **13.09.89 GB 8920745**

(43) Date of publication of application:
**20.03.91 Bulletin 91/12**

(84) Designated Contracting States:
**CH DE ES FR IT LI NL**

(71) Applicant: **AMP-AKZO CORPORATION**
**322 South Service Road**
**Melville, NY 11747(US)**

(72) Inventor: **Dekleva, Thomas William**
**710 Dawson Drive**
**Newark, Delaware 19713(US)**
Inventor: **Firmstone, Michael George**
**The Heath**
**Runcorn, Cheshire, WA7 1SP(GB)**

(74) Representative: **Königseder-Egerer, Claudia D.**
**Zugspitzstrasse 65**
**W-8104 Grainau(DE)**

(54) Thick film resistor/integrated circuit substrate and method of manufacture.

(57) Integrated circuit boards having a unique resistor-/conductor junction are disclosed made by air firing thick film resistor compositions overlapping a pattern of first metal conductors which are thereafter plated with a low resistance metal to form a plated conductor pattern. Boards having encapsulated resistor/conductor junctions remain stable after accelerated environmental agings.

FIG. 1A

EP 0 417 749 A2

## THICK FILM RESISTOR/INTEGRATED CIRCUIT SUBSTRATE AND METHOD OF MANUFACTURE

The invention relates to a hybrid integrated circuit substrate having a unique resistor/conductor interconnect and a method for its manufacture. In particular, this invention is directed to an air fired thick film resistor/electroplated copper circuit arrangement which features a resistor/noble metal/electroplated metal interconnect. It also relates to a method of manufacture which allows electroplated copper circuitry to be included with air fired thick film resistors and other active or electroactive thick film components on hybrid integrated circuit substrates.

In the manufacture of circuit boards or circuit substrates for use in an LSI package and the like, a high degree of integration is required. In order to obtain such a high degree of integration, it is necessary to apply a larger number of signal lines in a single or multilayer circuit board in small areas, namely with the formation of a fine connection pattern, and to provide low resistance signal lines. Since a hybrid integrated circuit, including attendant peripheral devices, need to be functionally operated, it is necessary to obtain a high reliability and a high degree of functionality by use of thick film resistors of high reliability, as well as the use of conductors having excellent electrical and physical properties.

Most high reliability thick film circuits employ conductor systems based on pastes of the noble metals gold, silver, palladium, and platinum, alone or in combination, and resistor systems based on pastes of ruthenium oxide-based materials, which are fixed on an insulating heat resistant substrate such as glass or ceramic, notably alumina. These thick film pastes are blends of conductive metals or metal oxides, nonconductive inorganic oxides, and organic binders and rheological aids. Conventional techniques employed in their use, namely screen printing, limit achievable line widths in production to greater than 125 micron. Also, screen printed conductors generally have poorly defined cross-sections and serrated edges, both which contribute to electrical losses at high frequencies. Even though recent progress has been made to reduce line widths and improve line geometries, the conductors continue to have electrical properties inferior to those of the bulk metals. Most recently, and mainly in response to economic factors, conductor systems based on copper have been developed to replace the precious metal systems. These systems also address the desirability of incorporating copper circuitry in hybrid applications. Unfortunately, in addition to the problems cited above, these systems need to be processed in nitrogen atmospheres to prevent gross oxidation problems, and the attendant control systems to do this reliably are expensive to operate. Moreover, in order to functionalize these systems, it has been necessary to develop resistor compositions which are designed to be fired in nitrogen atmospheres. The properties of these resistors, even when processed under ideal conditions, are inferior to air firing systems. Air firing thick film resistor compositions of the state of the art are capable of providing very reliable and stable devices, which commercial systems allowing for accessibility of the resistance range of less than 1 ohm to greater than 10 million ohms per square. However, in some cases, their performance is limited by the fact that they are terminated with thick film conductor systems. For example, it is quite common practice to use thick film resistors with silver/palladium conductors. When the systems are fired in the necessary presence of one another, there is interdiffusion of components, mainly silver, which significantly alters resistance values by providing volumes of the resistor which are silver rich. In many applications, accounts can be taken of this interdiffusion by use of calibration curves. Problems of instability arise during laser trimming, when cuts are inadvertently made in this region. This situation is unavoidable and becomes a particular problem in processing small resistors (less than 1 mm$^2$) in which the entire resistor is doped in this way.

For this reason, small, high reliability resistors are generally terminated with gold thick film systems. Under these circumstances, there is minimal interdiffusion of the conductor metal (gold) into the resistor body, though interdiffusion of bonding glasses can still alter resistance values, and calibration curves are still employs Unfortunately, gold dissolves in solder commonly used in component attachment. Also, problems arise due to mismatches of coefficients of thermal expansion (CTE). Because of the difference in CTE between substrate (approx. 20 ppm/°C), the developed strain occurs at the substrate-conductor-resistor interface, and is particularly acute with small area, low ohm resistors.

Thin film technology is capable of producing very fine lines of high quality; however, processing and equipment cost are high and throughput of vacuum deposition equipment is limited and, therefore, results in low volume production. While thin film resistors have tight tolerances and do not suffer the problems of doping or CTE mismatch, they are very limited in their resistance range, and the advantage of high packaging densities may be lost if large value resistors are required.

In the practice of the present invention, problems associated with the prior art technology discussed above are substantially eliminated. The circuit board of the present invention comprises a non-conductive base surface having a predetermined pattern of a thin, first metallic conductor layer bonded thereto, resistor interconnects, and a second layer of plated low resistance metal bonded to said first conductor layer whereby said resistor interconnects are bonded directly to said base layer and overlay or overlap said first conductor layer.

In one embodiment, the resistor interconnects are bonded directly to said base surface and directly to said first metallic layer at an overlap, and an encapsulant partially or completely covers said resistor interconnects and bonds directly to said surface and said first metallic layer to form a seal herewith.

The present invention encompasses a hybrid circuit board comprising a base selected from alumina, beryllia, aluminum nitride, and thick film dielectrics; a conductive pattern formed of thin oxidation resistant metal adhered to the base, said metal being selected from gold, silver, palladium, platinum and nickel; at least one resistor on the base and bonding to the base surface, said resistor making a connection to the conductive pattern by overlaying or overlapping a portion of the conductive pattern and binding to the oxidation resistant metal; and a conductive metal pattern plated on portion of the oxidations resistant metal pattern not covered by the resistor, said metal being selected from copper, silver and gold.

The present invention further claims a method of manufacturing a circuit board comprising the steps of providing a substrate having a non-conductive base surface; forming on said base surface a first metallic conductor layer, said layer being composed of an oxidation resistant metal and formed in a predetermined pattern, leaving exposed predetermined portions of the base layer; printing a resistor precursor composition on exposed portions of said base surface, said composition overlapping portions of said first conductor layer; heat treating the substrate to form a resistor body on the base surface from the pre-cursor composition, the resistor forming a connection to the first conductor layer at the overlap; and forming a second conductor layer of low resistance metal in a predetermined pattern, said second conductor layer overlaying portions of said first metallic conductor layer adjacent to the resistor body, the second conductor layer being electrically connected to the resistor through the first conductor layer.

A principal advantage of the present invention is that high density circuit boards can be formed which contain both air fired thick film resistors and plated copper circuitry, without compromising the excellent performance characteristics of either component. This allows for the production of circuit boards which exhibit high reliability and high circuit densities.

Another advantage of the present invention is that the use of low resistance metal allows conductors of reduced physical dimensions to be made while retaining optimal signal transmission characteristics. Another advantage of the present invention is that small area resistors can be prepared under conditions for which both the stresses of CTE mismatch and physical and chemical interactions between the resistors are greatly reduced or minimized, relative to standard thick film technologies.

A still further advantage of the present invention is that these electrically desirably effects can be obtained employing relatively inexpensive equipment associated with air firing.

These and other objects, features, aspects and advantages of the invention will become more apparent with reference to the following detailed description, when taken in conjunction with the accompanying drawings.

Fig. 1 is a partial sectional view taken along line A-A' of the top view Fig. 2 exclusive of protective insulating layer 4.

Fig. 1A is a partial sectional view taken along line A-A' of the top view Fig. 2 including the protective insulating layer 4.

Figs. 3, 4 and 5 are bar graphs showing changes in resistances for embodiments of the invention after aging at $105^\circ$ C, at $85^\circ$ C and 85% relative humidity, and after solder dipping, respectively.

The interconnect containing integrated circuit board of the invention is manufactured according to a general method of the invention as follows.

The circuit board comprising a non-conductive base surface having a predetermined pattern of a thin, first metal conductor layer bonded thereto, resistor interconnects, and a second layer of plated, low resistance metal bonded to said first conductor layer whereby said resistor interconnects are bonded directly to said base layer and directly to said first metal layer at an overlap, is made comprising the following steps:

(a) providing a non-conductive substrate;

(b) forming on said surface a single or a plurality of portion(s) of a first metallic conductor layer having a predetermined pattern;

c) forming a thick film resistor body over a portion or portions of said first conductor layer by heat treating a thick film precursor composition, such that it connects to portions of said non-conductive base surface and on top of portions of said first metallic conductor layer to form an overlap/overlay; and

(d) plating a low resistance conductor layer over said first metallic layer to a predetermined thickness.

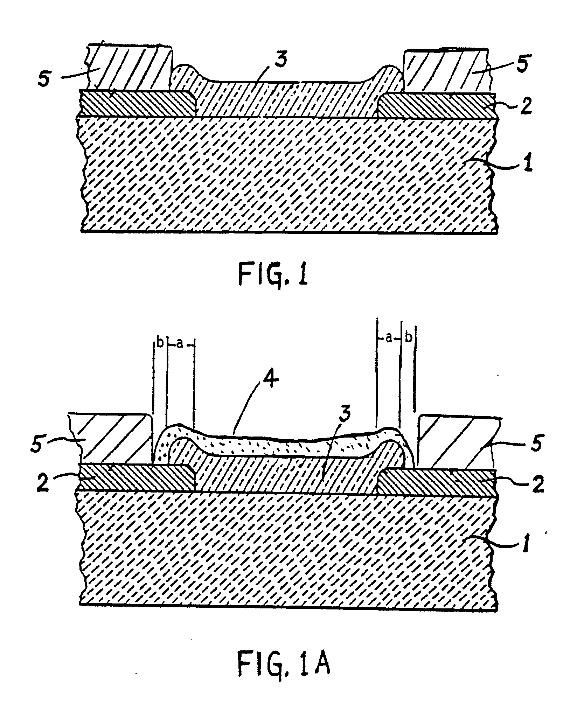

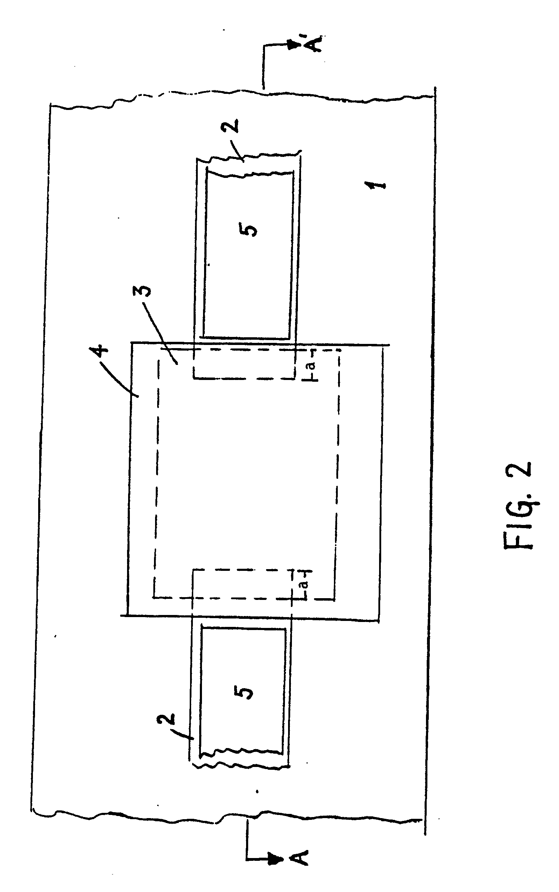

The process of the invention is carried out such that the resistor overlay 3 referred to in Figs. 1 and 1A overlaps with the first conductor layer 2 such that overlap a is at least 0.1. mm. If the resistor is encapsulated prior to plating, the encapsulating material is applied to form an overlap with the first conductor layer and base layer such that the dimension b of Figs. 1A and 2 amounts to at least 0.1 mm.

Referring to Fig. 1, fabrication of a circuit begins with a substrate 1 which is normally composed of 96% alumina. This is cleaned in accordance with standard techniques. A thin film (less than about 1 micron) of the conductive layer 2, made of adherent metal or metal mixture is provided on substrate 1. The first conductive layer 2 is formed by selectively patterning, by screen printing, and firing an organometallic precursor layer of precious metal, e.g., gold. Gold resinates are admix tures of solubilized gold, solubilized metals and/or metalloids whose presence effect adhesion, continuity, color, and luster, and organic vehicle and rheological aids. They can be fired in a belt or box furnace for, depending on their composition, times greater than 10 minutes at temperatures grater than 150° C, though preferably, for times greater than 30 minutes with peak temperatures of 750°-950° C. Compositions often have firing ranges of 600°-1000° C.

Subsequently, a thick film resistor 3 (Fig. 1) is formed to be connected to the first conductor layer 2. This thick film resistor 3 is formed by firing in air paste containing, e.g., ruthenium oxide or metal ruthenates in a belt furnace under oxidizing conditions. Each vendor of such pastes specifies slightly different profiles, though a typical one entails a 45 minutes cycle with the part being exposed for 10 minutes at a peak temperature of approximately 850° C, or, depending on the composition, in the range of 550°-950° C.

Referring to Fig. 1A, the first resistor can be encapsulated to protect it from the subsequent damage. Chemically resistant glass coatings formed from glass containing pastes are preferred. Alternatively, the resistor can be encapsulated by an organic or inorganic material which, after appropriate thermal or photolytic cure schedules, becomes insulating and chemically resistant to plating solutions. For higher sheet resistivity resistors, this protective coating can be derived from within the resistor body itself, forming during the normal firing sequence. That is, the glassy phase within the resistor compositions themselves are impervious to process chemicals and are environmentally stable and the resistor bodies themselves have surfaces which are sufficiently non-conductive that they do not accept metal during the electroplating process.

The substrate with or, as appropriate, without encapsulant 4 is mounted to a plating fixture, and the entire assembly is immersed in an acid copper plating bath consisting of sulfuric acid and copper sulfate and one of several organic brightener systems. The electric potentials are configured so that the gold conductive layer acts as the cathode, and the electric current is applied to allow copper deposition to form the second conductive layer 5 onto the gold. Plating times and current densities are adjusted to provide appropriate copper thick nesses. The cross section of the resulting substrate and circuit is represented schematically in Fig. 1 and 1A.

In principle, any base non-conductive material 1 used in the production of printed hybrid circuit boards can be used with the novel arrangement, provided it has the chemical and thermal stability to withstand the processing conditions. Ceramic or glass-ceramic substrates including several grades of aluminas, beryllia, aluminum nitride, and thick film dielectrics at various stages of sinter can be used with cermet thick film resistors. Organic based substrates, selected from insulating thermosetting, crosslinkable, thermoplastic resins and mixtures thereof may be used with polymer thick film resistors.

Although in the above mentioned embodiment, a gold resinate is exemplified as the first conductive layer, the same effect will be obtained by using other mixed solutions or suspensions of precious and/or other metals or metal oxides insofar as they can be formed into a desired pattern and the resulting films remain conductive or can easily be made conductive after firing the resistors under oxidative conditions. Metals such as gold, silver, palladium, platinum, nickel, and admixtures thereof, can serve in this capacity.

The deposition of the first conductor layer can be achieved by thermally induced metallo-organic decomposition and/or any of other several techniques employing selective vapor deposition, sputtering, laser inducing metallo-organic decomposition, or electroless plating. Patterning of the first conductor layer can be defined by screen printing and/or photolithography and etching.

Regarding the encapsulating material 4, any material can be used which satisfies the conditions of adhesion to the resistor material, chemical resistance, and electrically insulating. Preferred materials are those whose properties are derived by photolytic activation or by temperatures below 600° C, or at least 100° C below the firing temperature of the resistors. Filled and unfilled polyimide, epoxy, acrylic and phenolic based resins, and several low melting lead borosilicate glasses which satisfy the above criteria can also be used.

Although in the above mentioned embodiment the copper conductors were defined by the presence or absence of the conductive gold layer, it should be recognized that finer line geometries can be obtained by using photo-sensitive resists and photolithographic methods, and subsequent etching of residual exposes gold with, for example, $KI/I_2$ solutions. In addition to electrolytic copper, electroless copper and other plated low resistance metals, for example silver or gold, can be used in thicknesses typically ranging from 10-20 microns.

The product and process of the invention are better understood with reference to the following non-limiting examples. In these examples will be described some of the unexpected properties and advantages attendant to this invention.

## EXAMPLE 1

A series of circuit boards were made using Coors 96% alumina as the base material. These were cleaned by heating them in air to 950°C for 30 minutes. A thin film of a gold resinate paste containing 10-15% gold and lesser amounts of organometallic components, which ultimately yield oxides of aluminum, bismuth, chromium, copper, rhodium, silicon, silver, sodium, and tin was selectively deposited by screen printing to form a predefined pattern of interrupted area onto the substrate using a 325 mesh, 0.5 mil emulsion stainless screen. This coating was dried at room temperature for 15 minutes, 80°C for 15 minutes, and finally fired at 900°C in air to yield a conductive film approximately 0.2-0.3 microns thick with a sheet resistivity less than 200 milli-ohm per square.

Thick film resistor pastes were printed to 25 microns (pre-fired) dry print thicknesses, with areas ranging from 1.5 mm x 1 mm to 6 mm x 2.5 mm. These were printed such that the main resistor bodies were positioned on areas of bare alumina substrate, but overlaid the gold conductor areas with overlaps of 0.5 mm at each end to form interconnects. The final resistor areas (excluding overlap) ranged from 0.5 mm x 1 mm to 5 mm x 2.5 mm. The resistor pastes used were the 7 members of the DuPont 17G resistor series (1710, 1720, 1730, 1728, 1738, 1748 and 1758). The pastes were dried at room temperature for 15 minutes, at 125°C for 15-20 minutes, and then fired in air for 45 minutes in a BTU Fast Fire belt furnace, with the parts being exposed up to 10 minutes at a peak temperature of 870°C.

The resistors were encapsulated by screen printing a glass paste formulation containing oxides of aluminum, boron, chromium, and silicon, and firing the assembly in air for 60 minutes with the parts being exposed to a peak temperature of 600°C for 5 minutes. The glass extended past the resistor body approximately 0.125-0.5 mm in all horizontal directions.

The circuit substrates were laminated with Dynachem AX semiaqueous dry film photoresist, and imaged and developed according to the process procedure recommended by the supplier, to define the conductor areas immediately adjacent to the encapsulated resistor body for copper electroplating.

The circuit boards were then mounted in a copper plating fixture, such that all the portions of the gold underlayer were electrically connected to the plating fixture, and entirely immersed in a standard copper plating bath consisting of sulfuric acid, copper sulfate, and an organic brightener system. Each board was plated at 2.2 amperes per square centimeter for sufficient times to yield plated copper thicknesses of 12-15 microns. The boards were rinsed and dried, the residual photoresist was removed with solutions of methylene chloride/ methanol, and the exposed gold was removed using available etchants to yield electrically viable circuits.

The resistors were laser trimmed to 1.5 times their as-fired values and tested.

The properties only of the thick film resistors prepared using these procedures have been described in an article by T.W. Deklava and D.B. James, "High Density Electroplated Copper Circuitry Incorporating Air Firing Thick Film Resistors", ISHM 1988 Proceedings, pp. 554-566. The resistors incorporated in the copper circuitry exhibited stabilities at least as good as the manufacturer's claims for resistors on gold thick films.

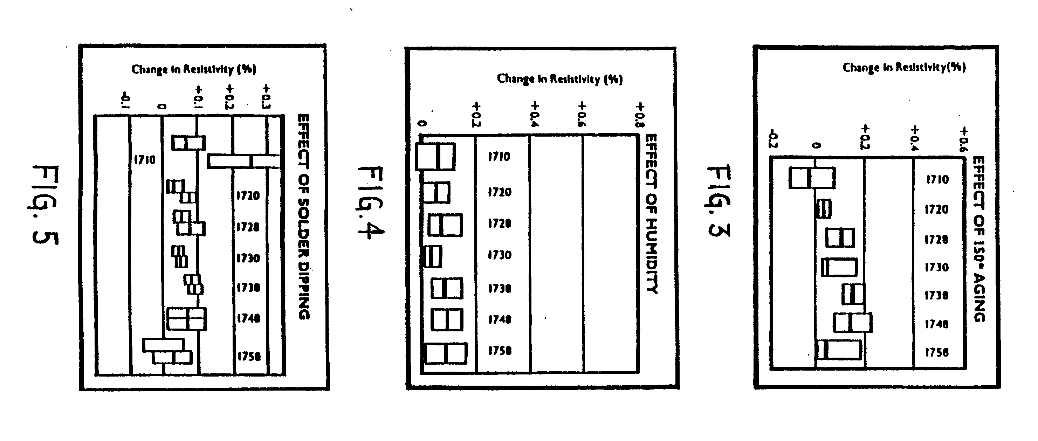

Changes in resistances after aging at 150°C for 1000 hours are shown in Fig. 3.

Changes in resistances after aging at 85°C in an atmosphere of 85% relative humidity are shown in Fig. 4.

Changes in resistances after dipping the resistors into 63:37 Sn:Pb solder, both once for 5 seconds at 230°C (left) and 10 x 10 seconds at 245°C (right) are shown in Fig. 5.

## EXAMPLE 2

One set of samples were prepared exactly as described in Example 1, except in this case, the pattern used also allowed for the formation of 0.5 mm x 0.5 mm resistors. A second set was prepared in the same way, except that the (pre-fired) dry print resistor thicknesses were 15 microns. For comparison, boards of identical pattern were prepared as controls according to Dupont's specifications using their recommended gold thick film terminating paste (composition 5715) in place of the copper plated resinate gold. No encapsulant was used on the thick film terminated control parts, also in accordance with Dupont's recommendations. None of either resistor type was laser trimmed.

Samples prepared according to the present invention consistently has less variability in value than did those prepared with conventional thick film terminations. Coefficients of variation (C of V) defined as (one standard deviation)/(mean value), are typically used as the figure of merit in measuring scatter (Table I). Smaller scatter is seen as advantageous, in that it allows laser trimming to be done more efficiently, and so more economically.

Samples of both types were then exposed to 200 cycles of liquid-liquid thermal shock (-65°C to +150°C). Resistance changes were recorded for resistors before and affer this treatment, Samples prepared with the 1710 (10 ohm) ink showed changes according to Table II. Resistors, particularly the smaller resistors, had better stability with the plated copper circuit than did those with the gold thick film terminators. A comparison of coefficients of variation (C of V) for resistors prepared in accordance with Example 2 and those made according to conventional thick film technology. Data for untrimmed 0.5 x 0,5 mm resistors. Coefficients of variation (C of V) are defined as (one standard deviation)/(mean value).

TABLE I

| Resistor | Terminator | C of V 25 micron print | C of V 15 micron print |
|---|---|---|---|
| 1710 | 5715 Au | 11.6 % | 6.0 % |
|  | present Cu | 4.8 % | 4.0 % |
| 1720 | 5715 Au | 11.0 % | 6.2 % |
|  | present Cu | 5.5 % | 3.6 % |
| 1728 | 5715 Au | 12.2 % | 6.7 % |
|  | present Cu | 5.5 % | 3.2 % |
| 1730 | 5715 Au | 12.2 % | 9.5 % |
|  | present Cu | 7.6 % | 5.5 % |
| 1738 | 5715 Au | 14.2 % | 7.1 % |
|  | present Cu | 7.8 % | 3.4 % |
| 1748 | 5715 Au | 14.7 % | 7.3 % |
|  | present Cu | 6.3 % | 5.7 % |
| 1758 | 5715 Au | 15.0 % | 20.8 % |
|  | present Cu | 9.0 % | 20.3 % |

A comparison of untrimmed resistor stabilities for thick film resistors prepared in accordance with Example 2 and those made according to conventional thick film technology. Date for resistance changes observed after samples were subjected to 200 cycles of liquid/liquid thermal shock (-65°C to +150°C), for the 1710 (10 ohm) resistors.

TABLE II

| Resistor Size (L x W) | 25 micron print on 5715 Gold | 25 micron print on present Cu | 15 micron print on present Cu |
|---|---|---|---|
| 0.5 x 0.5 mm² | +0.61 + 0.10 % | -0.06 + 0.04 % | -0.01 + 0.04 % |
| 0.5 x 1.0 mm² | +0.51 % | -0.05 % | -0.05 % |
| 1.0 x 1.0 mm² | +0.50 % | -0.05 % | -0.05 % |
| 2.0 x 2.0 mm² | +0.22 % | -0.10 % | -0.05 % |
| 10 x 2.0 mm² | +0.26 % | -0.05 % | -0.05 % |

One further quality of the resistors prepared according to the present invention was particularly unexpected. It relates to the ability of the free-standing gold gap (length "b" in Fig. 1A) to carry current.

During a load life experiment, a relatively high overload voltage was inadvertently applied to a 10 ohm resistor (resistor body was 1 x 1 mm prepared with the 1710 paste), such that an instantaneous power overload occurred, which lead to a catastrophic failure of the circuit. Visual examination of the circuit revealed that the resistor body, and not the section of freestanding gold, had been destroyed. The performance of the circuit was not limited by the gold-copper construction, but by the thick film resistor.

**Claims**

1. A circuit board comprising a non-conductive base surface having a predetermined pattern of a thin, first metallic conductor layer bonded thereto, resistor interconnects, and a second layer of plated low resistance metal bonded to said first conductor layer whereby said resistor interconnects are bonded directly to said base layer and overlay or overlap said first conductor layer.

2. The circuit board of claim 1 wherein said resistor interconnects are bonded directly to said base surface and directly to said first metallic layer at an overlap, and an encapsulant partially or completely covers said resistor interconnects and bonds directly to said surface and said first metallic layer to form a seal herewith.

3. The circuit board of claim 1 or 2 wherein the portion of the resistor overlaying or overlapping the metallic conductor layer is at least 0.1 mm long.

4. The circuit board of claim 1 or 2 wherein the portion of the resistor overlaying or overlapping the metallic conductor layer is at least 0.5 mm long.

5. The circuit board of claim 1 wherein said non-conductive base surface is a ceramic selected from alumina, beryllia, aluminium nitride, silicon carbide, crystallizable glass, non-crystallizable glass, ceramic filled glass dielectrics, and glass ceramic composites.

6. The circuit board of claim 1 wherein said non-conductive base surface comprises a high temperature thermoset or thermoplastic resin or mixtures thereof, and said resistor is derived from a polymeric thick film precursor composition.

7. The circuit board of claim 1 wherein the first or the first and the second conductor layer(s) is (are) composed of one or more oxidation resistant metals.

8. The circuit board of claim 1 wherein said first metallic conductor layer contains primarily gold, silver, platinum, nickel, ruthenium, rhodium, or iridium, or mixtures thereof.

9. The circuit board of claim 1 wherein said first conductor layer contains primarily gold.

10. The circuit board of claims 1 to 9 wherein said first conductor layer is 0.1 - 25 microns thick.

11. The circuit board of claims 1 to 9 wherein said first conductor layer is 0.1 - 5 microns thick.

12. The circuit board of claims 1 to 9 wherein said first conductor layer is 0.1 - 0,5 microns thick.

13. The circuit board of claims 1 to 12 wherein said resistor contains ruthenium oxide and/or derivatives thereof.

14. The circuit board of claims 1 to 12 wherein said resistor contains palladium, silver, rhodium, iridium, or derivatives or mixtures thereof.

15. A hybrid circuit board comprising a base selected from alumina, beryllia. aluminum nitride, and thick film dielectrics; a conductive pattern formed of thin oxidation resistant metal adhered to the base, said metal being selected from gold, silver, palladium, platinum and nickel; at least one resistor on the base and bonding to the base surface, said resistor making a connection to the conductive pattern by overlaying or overlapping a portion of the conductive pattern and binding to the oxidation resistant metal; and a conductive metal pattern plated on portion of the oxidations resistant metal pattern not covered by the resistor, said metal being selected from copper, silver and gold.

16. A method of manufacturing a circuit board comprising the steps of
providing a substrate having a non-conductive base surface;
forming on said base surface a first metallic conductor layer, said layer being composed of an oxidation resistant metal and formed in a predetermined pattern, leaving exposed predetermined portions of the base layer;
printing a resistor precursor composition on exposed portions of said base surface, said composition overlapping portions of said first conductor layer;
heat treating the substrate to form a resistor body on the base surface from the precursor composition, the resistor forming a connection to the first conductor layer at the overlap; and
forming a second conductor layer of low resistance metal in a predetermined pattern, said second conductor layer overlaying portions of said first metallic conductor layer adjacent to the resistor body, the second conductor layer being electrically connected to the resistor through the first conductor layer.

17. The method of claim 16 wherein the oxidation resistant metal comprises gold, silver, palladium, platinum, nickel, and admixtures thereof.

18. The method of claim 16 or 17 wherein the oxidation resistant metal layer is formed on said surface by chemical vapor deposition, thermal or laser-induced metallo-organic deposition, sputtering or electroless plating, and the predetermined pattern is defined by laser decomposition, screen printing or photolithography and etching, or a combination thereof.

19. The method of claims 16 to 18 wherein the substrate is selected from alumina, beryllia, aluminum nitride, silicon carbide, crystallizable glass, non-crystallizable glass, ceramic filled glass dielectric, and glass-ceramic composites, and the predetermined pattern of oxidation resistant metal is formed on the substrate by screen printing an organometallic composition containing solubilized gold and lesser amounts of organometallic compositions of aluminum, bismuth, chromium, copper, rhodium, silicon, silver, sodium and tin, and mixtures of the foregoing; and thermally decomposing the organometallic composition to metallic gold containing lesser amounts of metallic oxides by firing the substrate.

20. The method of claim 16 wherein the second conductor layer is formed by plating a low resistant metal selected from copper, silver and gold.

21. The method of claim 16 wherein, prior to forming the second conductor layer, the resistor is encapsulated with an insulating coating.

22. The method of claim 16 wherein the resistor and at least part of the exposed conductor layer(s) is encapsulated with an insulating coating.

FIG. 1

FIG. 1A

FIG. 2

EP 0 417 749 A2

FIG. 3

FIG.4

FIG. 5